# EUROPEAN PATENT APPLICATION

(11) **EP 2 273 673 A1**
(43) Date of publication of application: **12.01.2011**
(21) Application number: 09730605.4
(22) Date of filing: 10.04.2009
(51) Int. Cl.: H03G 1/04, G10L 21/02, H03G 3/20, H03G 7/06, H04R 3/04

(54) **AUDIO SIGNAL PROCESSING DEVICE AND AUDIO SIGNAL PROCESSING METHOD**

(30) Priority: 10.04.2008 JP 2008102232
(71) Applicant: Sharp Kabushiki Kaisha, Osaka-shi, Osaka 545-8522 (JP)
(72) Inventor: URATA, Shigefumi, Osaka-shi Osaka 545-8522 (JP)
(74) Representative: Müller - Hoffmann & Partner
(86) International application number: PCT/JP2009/057361
(87) International publication number: WO 2009/125840

(57) **Abstract**

A technique is provided that can reduce any unnecessary distortion components of an input audio signal that arises as a result of varying the gain of the signal regardless of the type of the input audio signal.

As shown in FIG. 1, as signal Sin is input to audio signal processing apparatus 10, signal branching section 11 divides the signal Sin for first through N-th routes R1 through Rn. On the first through N-th routes R1 through Rn, first through N-th front BPFs 111 through 11n respectively selects the predetermined frequency bands set for the signals and outputs them to first through N-th AGCs 121 through 12n. The first through N-th AGCs 121 through 12n respectively adjusts the gains of the acquired signals and output them to first through N-th back BPFs 131 through 13n. The first through N-th back BPFs 131 through 13n respectively eliminate the distortion components outside the bands by means of band limiting processes. Adder 60 synthetically combines the signals respectively subjected to band limiting processes and outputs the synthesized signal to a post-process processing means.

## Description

### Technical Field

The present invention relates to an audio signal processing apparatus and an audio signal processing method. More particularly, the present invention relates to an audio signal processing apparatus and an audio signal processing method for branching an audio signal for a plurality of routes and operating for a frequency band limiting process and for gain adjustment.

### Background Art

AGC (auto gain control) features have popularly been employed for compressing the dynamic range of sound in recent years. A process of varying the signal gain consists in amplitude modulation and various techniques of varying the amplitude at the time of zero-crossing and those of mildly varying the amplitude have been proposed to reduce the distortion that is produced as a result of a process of varying the signal gain. Of these, the latter is employed more often than not because a zero-crossing does not necessarily come at a desired timing with the former techniques. However, the latter varies the amplitude discretely (or stepwise) to sometimes give rise to a phenomenon of varying the amplitude periodically for a specific input signal to by turn produce a distortion that is not found in the original signal.

Techniques of adjusting the gain of the audio signal of each divided band and adding the audio signals and outputting them after adjusting the gains are known (refer to, e.g., PTL 1). Such techniques average the audio output levels, maintaining the sound quality of the high-frequency components, by means of the above-described arrangement.

### Citation List

### Patent Literature

PTL 1: Jpn. Pat. Appln. Laid-Open Publication No. 2003-299181

### Summary of the Invention

### Technical Problem

The technique of PTL 1 varies the gain moment by moment according to the input signal to give rise to a problem that a distortion can occur at the time of varying the gain so that the output signal may contain the distortion and hence requires improvements.

In view of the above-identified problem, it is therefore the object of the present invention to provide a technique of reducing any unnecessary distortion components of an input audio signal that arises as a result of varying the gain of the signal.

### Solution to the Problem

The apparatus according to the present invention relates to an audio signal processing apparatus. The apparatus includes: a first front band limiting means for executing a frequency band limiting process on a first audio signal; a first gain controlling means for controlling the gain of the first audio signal subjected to a frequency band limiting process by the first front band limiting means; a first back band limiting means for executing a frequency band limiting process on the first audio signal controlled for the gain by the first gain control means; and the first audio signal subjected to a frequency band limiting process by the first back band limiting means. The audio signal processing apparatus may further include a synthesizing means for synthetically combining the first audio signal and an audio signal from a route different from the route of the first audio signal.
The route for outputting the audio signal to be synthetically combined with the first audio signal to the synthesizing means may include: a second front band limiting means for executing a frequency band limiting process on a second audio signal; a second gain controlling means for controlling the gain of the second audio signal subjected to a frequency band limiting process by the second front band limiting means; and a second back band limiting means for executing a frequency band limiting process on the second audio signal controlled for the gain by the second controlling means; the second audio signal being output to the synthesizing means after the frequency band limiting process by the second back band limiting means.
The frequency band of the first audio signal limited for the band by the first front band limiting means and output may be set to be lower than the frequency band of the second audio signal limited for the band by the second front band limiting means and output.
The route for outputting the audio signal to be synthetically combined with the first audio signal to the synthesizing means may include: a third front band limiting means for executing a frequency band limiting process on a third audio signal; and a third gain controlling means for controlling the gain of the third audio signal subjected to a frequency band limiting process by the third front band limiting means, no back band limiting means for executing a frequency band limiting process on the third audio signal controlled for the gain being provided between the third gain controlling means and the synthesizing means, the third audio signal being output to the synthesizing means after the gain control by the third gain controlling means.
The route for outputting the audio signal to be synthetically combined with the first audio signal to the synthesizing means may include: a fourth front band limiting means for executing a frequency band limiting process on a fourth audio signal, neither a gain controlling means for controlling the gain of the fourth audio signal subjected to a frequency band limiting process nor a back band limiting means for executing a frequency band limiting process being provided between the fourth front band limiting means and the synthesizing means, the fourth audio signal being output to the synthesizing means after the frequency band limiting process by the fourth front band limiting means.
The route of the audio signal to be synthetically combined with the first audio signal may be a route for outputting the audio signal before being subjected to a band limiting process to the synthesizing means.
The frequency band liming process of the first front band limiting means and the frequency band limiting process of the first back band limiting means may be executed by a single band limiting means on a time sharing basis.
The characteristics of the second front band limiting means may be so set as to complement the frequency band of the first audio signal subjected to a frequency band limiting process by the first front band limiting means.
The method according to the present invention relates to an audio signal processing method to be used by an audio signal processing apparatus. The method includes: a route dividing step of branching an input audio signal for a plurality of routes; a band dividing step of dividing the audio signal for predetermined frequency bands by executing a frequency band limiting process on the audio signal in each divided route; a gain adjusting step of adjusting, if necessary, the gain of each audio signal of the divided bands; a distortion eliminating step of eliminating distorted signals produced in the gain adjusting step by executing a frequency band limiting process on each audio signal adjusted for the gain; and a synthesizing step of synthetically combining the audio signals divided for frequency bands after the end of the distortion eliminating step.
The distortion eliminating step may be omitted for any of the audio signals produced as a division for predetermined frequency bands that is not subjected to the gain adjusting step.

### Advantageous Effect of Invention

Thus, the present invention can provide a technique of reducing any unnecessary distortion component that is produced due to a gain variation of the input audio signal.

### Brief Description of Drawings

FIG. 1 is a functional block diagram of the audio signal processing apparatus according to the first embodiment of the present invention.
FIG. 2 is a flowchart of the process to be executed on an audio signal in the audio signal processing apparatus according to the first embodiment of the present invention.
FIG. 3 is a functional block diagram of the audio signal processing apparatus according to an experimental example of the first embodiment.
FIG. 4 is a graph illustrating the results of verification of Experiment 1 according to the experimental example of the first embodiment.
FIG. 5 is a graph illustrating the results of verification of Experiment 2 according to the experimental example of the first embodiment.
FIG. 6 is a functional block diagram of the audio signal processing apparatus according to the second embodiment of the present invention.
FIG. 7 is a functional block diagram of the audio signal processing apparatus according to the third embodiment of the present invention.
FIG. 8 is functional block diagram of the audio signal processing apparatus according to the fourth embodiment of the present invention.
FIG. 9 is a functional block diagram of the audio signal processing apparatus according to the fifth embodiment of the present invention.

### Reference Signs List

10, 10a to 10C, 210, 310: audio signal processing apparatus
11, 240, 340: signal branching section
20, 20a to 20c, 220, 320: signal processing section
60, 260, 360: adder
111, 211: first front BPF
111a: front BPF
112, 212: second front BPF
113: third front BPF
11n: N-th front BPF
121, 221: first AGC
121a: AGC
122: second AGC
12n: N-th AGC
131, 231: first back BPF
131a: back BPF
132: second back BPF
13n: N-th back BPF
311: first BPF
312: second BPF
31n: N-th BPF
321: first AGC
322: second AGC
32n: N-th AGC
330: switching instruction control section
351: front speed conversion section
352: back speed conversion section

### Best Mode for Carrying Out the Invention

Now, different modes for carrying out the present invention (to be simply referred to as "embodiments" hereinafter) will be specifically described below by referring to the accompanying drawings. Summarily, the processes of the embodiments include the steps listed below:
1) dividing an audio signal for a plurality of frequency bands;
2) adjusting the gain of the signal of each frequency band;
3) eliminating the gain fluctuation distortion component produced outside the band as a result of gain adjustment by means of a band dividing filter (BPF); and
4) synthetically combining the signals from which the distortion components are eliminated by means of BPFs to generate an output signal.
With the above steps, an output signal of sounds that are free from any noisy feeling can be produced.

### (First Embodiment)

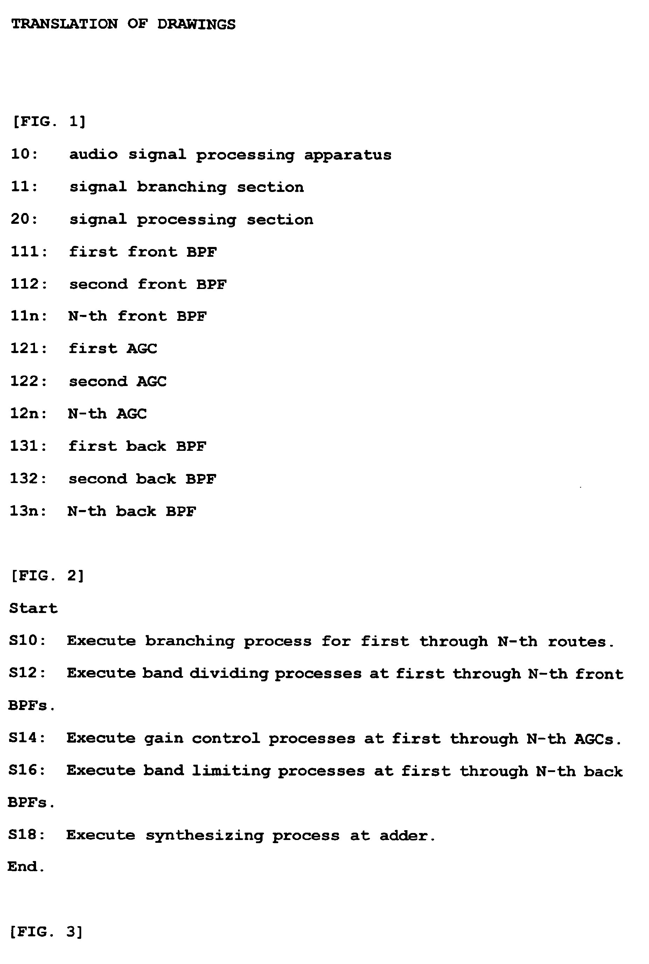

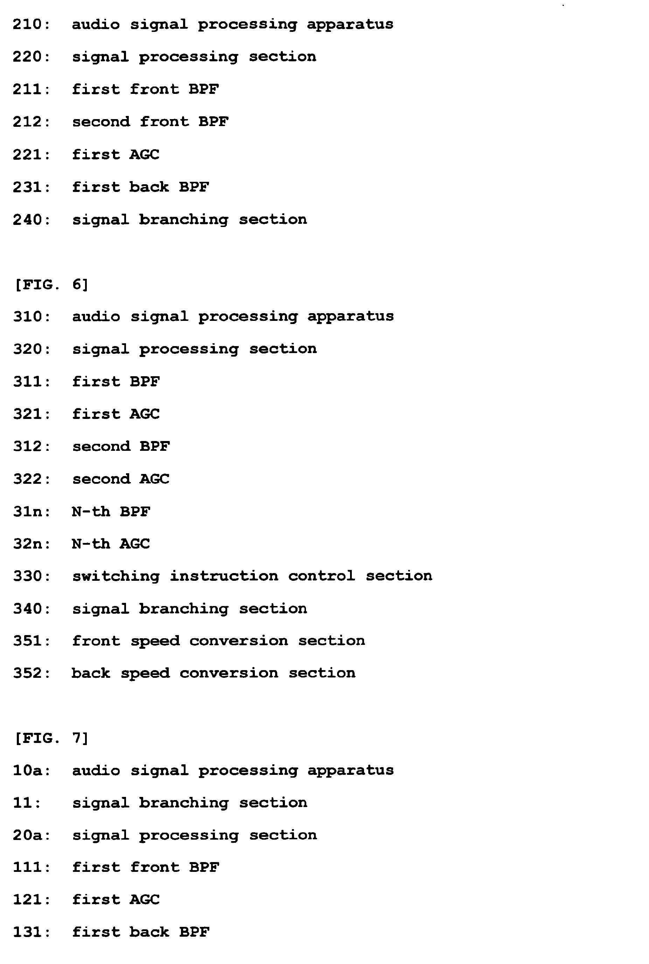

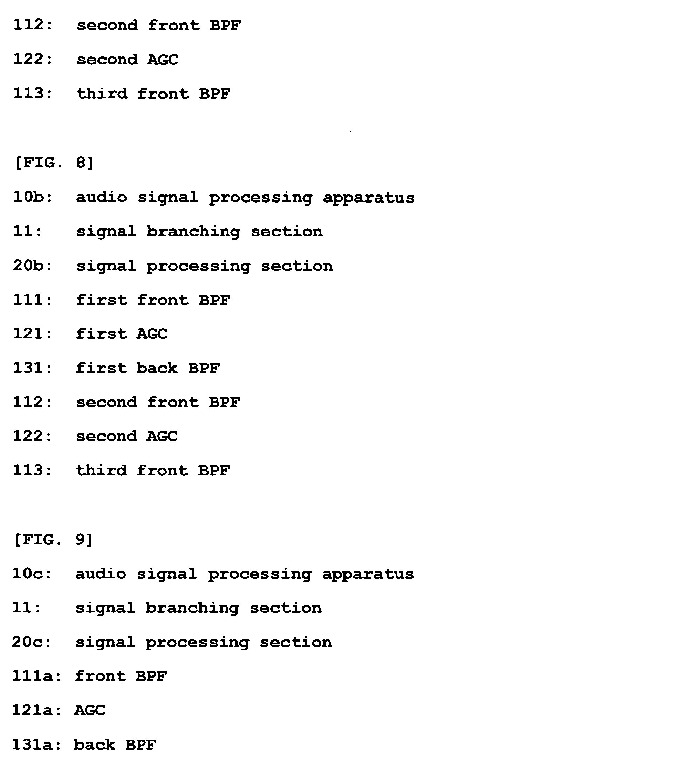

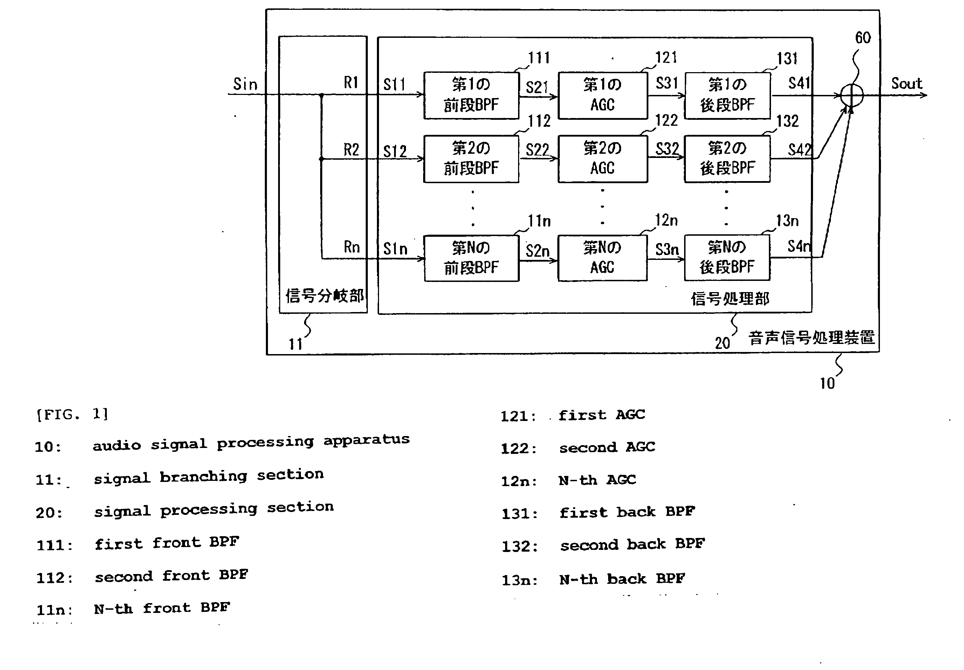

FIG. 1 is a functional block diagram of an audio signal processing apparatus 10 according to the first embodiment of the present invention. As shown, the audio signal processing apparatus 10 includes a signal branching section 11 for branching input audio signal Sin into signals S11 through S1n of first through N-th routes R1 through Rn, a signal processing section 20 for executing a predetermined signal process on the divided signals S11 through S1n and an adder 60 for synthetically combining signals S41 through S4n that are produced as a result of the processes executed at the respective routes of the signal processing section 20.

The signal processing section 20 has front BPFs for respectively executing frequency band processes on the divided signals S11 through S1n of the branch routes R1 through Rn, AGCs for gain adjustment of respective signals S21 through S2n produced as a result of frequency band processes and back BPFs for respectively executing frequency band processes on signals S31 through S3n produced as a result of gain adjustment. Note that, in the following description, among the routes R1 through Rn, a route that has all the three elements including a front BPF, an AGC and a back BPF is referred to as route of the first category and a route that has two elements including a front BPF and an AGC is referred to as route of the second category, while a route that has only a single element of a front BPF is referred to as route of the third category and a route that is devoid of all three elements is referred to as route of the fourth category. In the arrangement of FIG. 1, all the routes R1 through Rn are shown as routes of the first category.

More specifically, the first route R1 has a first front BPF 111, a first AGC 121 and a first back BPF 131 arranged in the above-mentioned order from the upstream side. Similarly, the second route R2 has a second front BPF 112, a second AGC 122 and a second back BPF 132. All the following routes have the same arrangement. In other words, the N-th route Rn has an N-th front BPF 11n, an N-th AGC 12n and an N-th back BPF 13n.

Note that it is so arranged that, of the first through N-th front BPFs 111 through 11n, the first front BPF 111 selects the lowest frequency band and the N-th front BPF 11n selects the highest frequency band. Signals S21 through S2n that are produced respectively from the first through N-th front BPFs 111 through 11n and whose frequency bands are limited are then output through the first through N-th AGCs 121 through 12n (as signals S31 through S3n). Therefore, the first front BPF 111 may be a low pass filter (LPF) and the N-th front BPF 11n may be a high pass filter. The first through N-th front BPFs 111 through 11n and the first through N-th back BPFs 131 through 13n, which will be described later, are typically IIR (infinite impulse response) filters that can be realized by a signal processing semiconductor integrated circuit such as a DSP (digital signal processor).

The first through N-th AGCs 121 through 12n respectively adjust the gains of the signals (signals S21 through S2n) of the respective routes (R1 through Rn) and output them to the first through N-th back BPFs 131 through 13n as signals S31 through S3n.

The first through N-th back BPFs 131 through 13n respectively have band characteristics same as those of the first through N-th front BPFs 111 through 11n arranged on the same routes. In other words, the band characteristics of the first through N-th back BPFs 131 through 13n are same as those of the first through N-th front BPFs 111 through 11n arranged on the same routes for the frequencies they select. Therefore, if any distortion component is produced outside the frequency bands that the first through N-th front BPFs 111 through 11n select in processes of the first through N-th AGCs 121 through 12n, the distortion component will be eliminated.

The adder 60 acquires the signals (signals S41 through S4n) subjected to a frequency band limiting process by the first through N-th back BPFs 131 through 13n and synthetically combines them to produce output signal Sout, which is output to an output device such as a speaker (not shown) or post-process processing means.

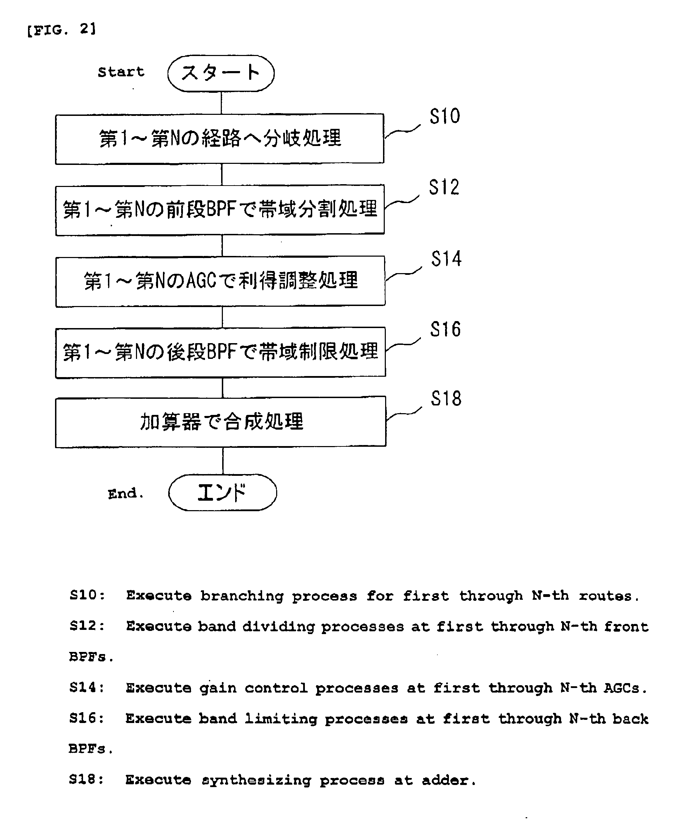

The above processes for an audio signal that are arranged in the above-described manner will be summarily described below by referring to the flowchart of FIG. 2.
As an audio signal Sin is input, the signal branching section 11 branches the signal Sin for the first through N-th routes R1 through Rn to obtain divided signals S11 through S1n for the respective routes (Step S10).

Then, the first through N-th front BPFs 111 through 11n on the first through N-th routes R1 through Rn selectively output the predetermined frequency bands that are pre-selected for them to the first through N-th AGCs 121 through 12n (as signals S21 through S2n) (Step S12).

The first through N-th AGCs 121 through 12n respectively adjust the gains of the signals S21 through S2n they acquire and output them to the first through N-th back BPFs 131 through 13n (as signals S31 through S3n) (Step S14).

The first through N-th back BPFs 131 through 13n respectively select the signals of the predetermined frequency bands that are pre-selected for the signals S31 through S3n whose gains are adjusted to eliminate the distortion components outside the bands and output the signals to the adder 60 (Step S16).

The adder 60 acquires the signals S41 through S4n that are respectively subjected to frequency band limiting processes in the first through N-th back BPFs 131 through 13n, synthetically combines them into an output signal (signal Sout) and outputs the signal Sout to an output device such as a speaker or a post-process processing means (Step S18).

Thus, with the above-described embodiment, the distortion components produced outside the frequency bands respectively selected by the first through N-th front BPFs 111 through 11n can be eliminated in the processes of the first through N-th AGCs 121 through 12n so that unnecessary components (distortion components) can be stably decreased to improve the sound quality of the signal generated by the adder 60 as a result of the synthetically combining operation. While a gain adjusting operation is conducted in each and every route in the above-described embodiment, the present invention is by no means limited to such an arrangement. From the viewpoint of preventing the speaker from being destroyed, generally the need of preventing an excessive input of low-frequency components is highest. Also, the user feels distortions most sensitively in low frequencies. Therefore, in a route for which a high-frequency signal is selected, which may be the N-th route Rn, a satisfactory signal quality may be secured if a gain adjusting operation is omitted there. In such a case, that AGC and the back BPF can be omitted to leave only the front BPF in the route. In other words, there may be one ore more than one routes that can be formed as route or routes not of the first category but of the second, third or fourth category. The third through fifth embodiments have such an arrangement. Alternatively, the front BPF and the back BPF may be made to show different characteristics. If there is a signal in a frequency band that does not involve any AGC in adjacent frequency bands, the characteristics of the frequency band of the BPF provided in the route that does not involve any AGC may be expanded to the frequency band of a route that involves AGC to complement the signal of the latter route. Both the front BPF and the back BPF execute a band limiting process on a route that involves AGC and hence the signal level can be lowered there. In such a case, it may sometimes be difficult to set the parameters of the two BPFs so as to decrease distortions, while preventing any significant fall of the signal level. Then, the parameters can be set with ease to improve the sound quality by complementing the signal of the route by the signal of a route that does not involve any AGC.

Now, the results of verification of the effects of the above arrangement and processes (Experiments 1 and 2) will be described below. For the purpose of checking the effects of the arrangement and processes, only two branch routes including the first rout R1 at the low-frequency band side and the second route R2 at the high-frequency band side are employed. No gain adjustment is conducted at the second route R2.

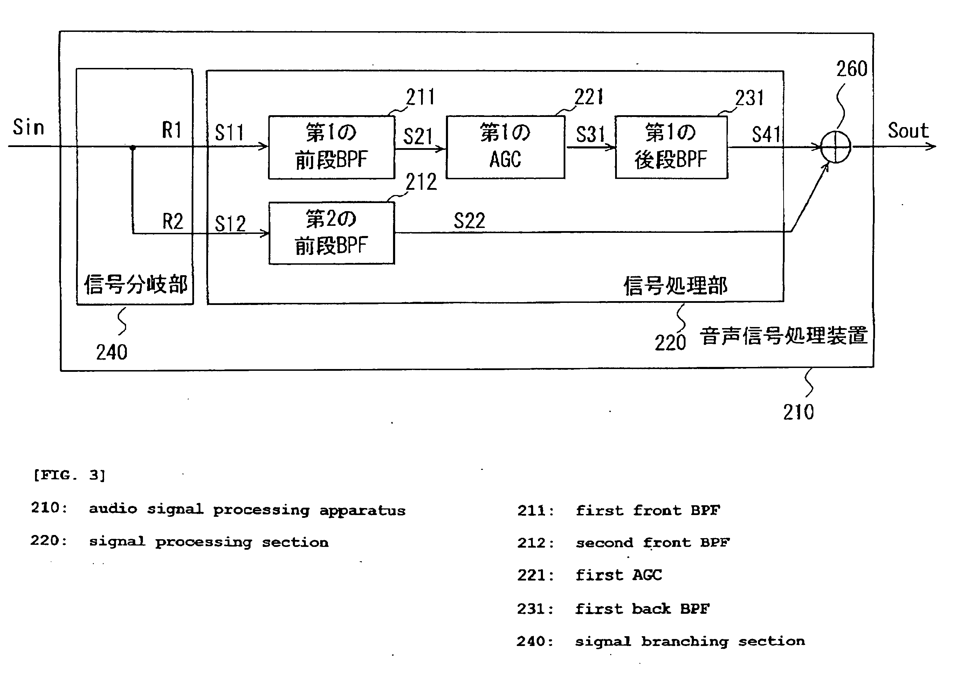

FIG. 3 is a functional block diagram of an arrangement of an audio signal processing apparatus 210 of the experimental example. As shown, the audio signal processing apparatus 210 includes a signal branching section 240, a signal processing section 220 and an adder 260.

The signal branching section 240 braches input audio signal Sin for the first and second routes R1 and R2 and outputs divided signals S11 and S12 to the signal processing section 220. The signal processing section 220 has a first front BPF 211, a first AGC 221 and a first back BPF 231 arranged in the above-mentioned order from the input side (the side of the signal branching section 240) on the first route R1 and only second front BPF 212 on the second route R2. The adder 260 synthetically combines a signal S41 produced from the first back BPF 231 as a result of a process executed on the first route R1 and a signal S22 produced from the second front BPF 212 as a result of a process executed on the second route R2 to produce output signal Sout.

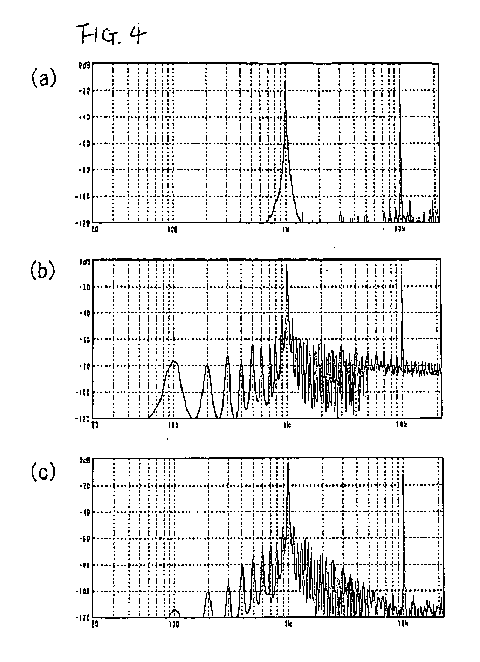

FIG. 4 is a graph illustrating the results of verification of Experiment 1 having the arrangement as shown in FIG. 3. FIG. 4(a) shows the frequency characteristic of the input signal and FIG. 4(b) shows the frequency characteristic (peak value) of the output signal produced by a conventional technique using only front BPFs, whereas FIG. 4(c) shows the frequency characteristic of the output signal of the arrangement of FIG. 3. The conditions of the experiments include the following:
input signal:
   1 kHz (-12.5 dB) + 10 kHz (-12.5 dB) synthetically combined sine waves
filter characteristics:
   band pass filter (center frequency 1 kHz, band width 670 Hz)
   bypass filter (cutoff frequency 4 kHz, secondary, Q: 1/2^{1/2}
AGC:
   largest gain +9 dB, threshold value -2 dB
   attack time 1 ms, release time 100 ms

As shown in FIG. 4(a), the input signal (original audio signal) is a signal that has center frequencies at 1 kHz and 10 kHz and does not contain practically any distortion. On the other hand, as shown in FIG. 4(b), the signal obtained as a result of a process of a conventional technique shows a distortion with a peak of about -80 dB near 100 Hz and other several distortions with peaks observed between 100 Hz and 1 kHz. Additionally, many distortions with peaks of about -60 dB to -80 dB are observed at the higher frequency side of 1 kHz.

To the contrary, with the technique proposed in this embodiment, as shown in FIG. 4(c), the produced distortions are suppressed at both at the low-frequency range side and at the high-frequency range side. For example, the peak of the distortion near 100 Hz is made as low as about -110 dB. In other words, from the peak levels of the distortions, it may be safe to say that there is practically no distortion on the signal and the characteristics of the signal are excellent.

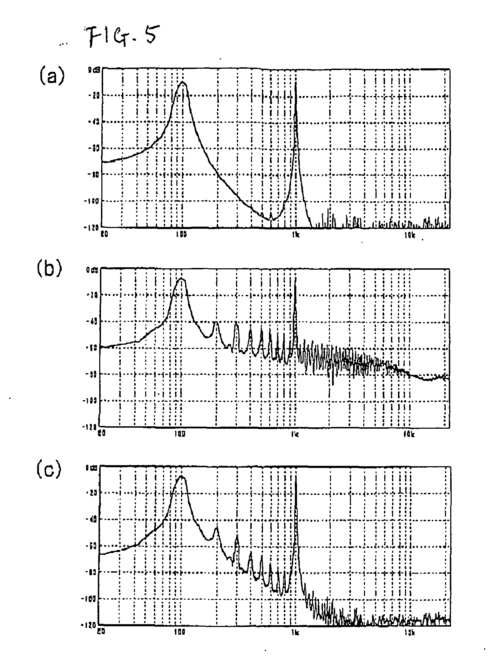

FIG. 5 is a graph illustrating the results of verification of Experiment 2 having the arrangement as shown in FIG. 3. FIG. 5(a) shows the frequency characteristic of the input signal and FIG. 5(b) shows the frequency characteristic (peak value) of the output signal produced by a conventional technique using only front BPFs, whereas FIG. 5(c) shows the frequency characteristic of the output signal of the arrangement of FIG. 3. The conditions of the experiments include the following, the input signal being one that is shifted from the signal of Experiment 1 to the low-frequency side:
input signal:
   100 Hz (-9.2 dB) + 1 kHz (-9.2 dB) synthetically combined sine waves
filter characteristics:
   band pass filter (center frequency 100 Hz, band width 60 Hz)
   bypass filter (cutoff frequency 180 Hz, secondary, Q: 1/2^{1/2}
AGC:
   largest gain +9 dB, threshold value -2 dB
   attack time 1 ms, release time 100 ms

As shown in FIG. 5(a), the input signal (original signal) is a signal that has center frequencies at 100 Hz and 1 kHz and does not contain practically any distortion. On the other hand, as shown in FIG. 5(b), the signal obtained as a result of a process of a conventional technique shows a distortion with a peak of about -40 dB near 200 Hz and a distortion with a peak of about -50 dB near 400 Hz at the low-frequency side. Distortions with peaks of about -60 dB to -80 dB appear at the high-frequency side beyond 1 kHz over a region covering frequencies higher than 10 kHz.

To the contrary, with the technique proposed in this embodiment, as shown in FIG. 5(c), the produced distortions are suppressed at both at the low-frequency range side and at the high-frequency range side. For example, the peaks of distortions near 200Hz are suppressed to about -50 dB, which is about 10 dB lower than the comparable level of FIG. 5(b), and the peaks of distortions near 400 Hz are suppressed to about -65 dB, which is about -15 dB lower than the comparable level of FIG. 5(b).

### (Second Embodiment)

In the second embodiment of this invention, a single BPF that performs a frequency band limiting process functions both as a front BPF and a back BPF on a time sharing basis on branched signal routes.

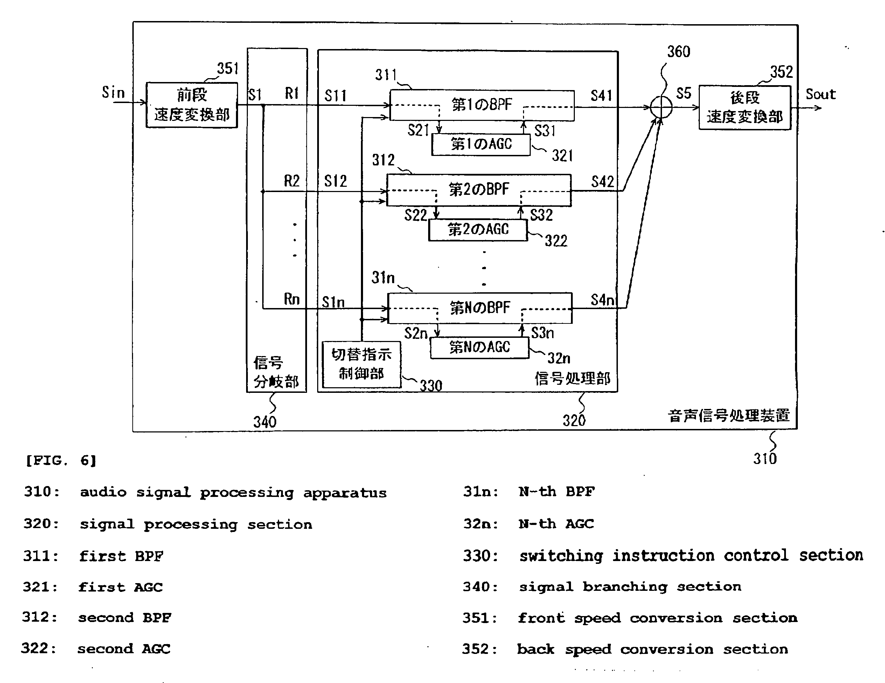

FIG. 6 is a functional block diagram of an arrangement of an audio signal processing apparatus 310 of the second embodiment of the present invention. Referring to FIG. 6, the audio signal processing apparatus 310 includes a front speed conversion section 351, a signal branching section 340, a signal processing section 320, an adder 360 and a back speed conversion section 352.

The front speed conversion section 351 converts the speed of signal Sin to not less than twice of the original speed in order to process the signal by means of a same and single BPF on a time sharing basis. Then, signal S1 produced as a result of conversion is output to the signal branching section 340. The signal branching section 340 operates same as the signal branching section 11 of FIG. 1 to branch the input signal S1 for first through N-th routes R1 through Rn and produce divided signals S11 through S1n.

The signal processing section 320 has BPFs for respectively executing frequency band processes on the divided signals S11 through S1n of the branch routes R1 through Rn and AGCs for gain adjustment of respective signals S21 through S2n produced as a result of frequency band processes. More specifically, the first route R1 has a first BPF 311 and a first AGC 321. Similarly, the second route R2 has a second front BPF 312 and a second AGC 322. All the following routes have the same arrangement. In other words, the N-th route Rn has an N-th BPF 31n and an N-th AGC 32n.

As the first through N-th BPFs 311 through 31n respectively acquire signals S11 through S1n produced from the signal branching section 340 as a result of signal branching, they execute predetermined frequency band processes on the signals S11 through S1n and output the processed signals (signals S21 through S2n) to the first through N-th AGCs 321 through 32n.

The first through N-th AGCs 321 through 32n respectively adjust the gains of the signals and output them to the first through N-th BPFs 311 through 31n (as signals S31 through S3n). The first through N-th BPFs 311 through 31n execute predetermined frequency band processes on the signals S31 through S3n whose gains are adjusted and output the processed signals (signals S41 through S4n) to the adder 360.

The signal processing section 320 additionally has a switching instruction control section 330 for determining if frequency band processes are executed on the signals **S11** through S1n acquired from the signal branching section 340 or on the audio signals S31 through S3n whose gains are adjusted and controlling the first through N-th BPFs 311 through 31n accordingly. In other words, the switching instruction control section 330 determines if the first through N-th BPFs 311 through 31n are to function as front BPFs or as back BPFs and directs the first through N-th BPFs 311 through 31n to function accordingly.

The signal S5 synthesized by the adder 360 is output to the back speed conversion section 352. Then, the back speed conversion section 352 restores the original speed of the signal S1 that is subjected to conversion by the front speed conversion section 351 and outputs (signal S5) to an audio output device such as a speaker.

Thus, this embodiment can provide effects similar to those of the first embodiment. Additionally, since same BPFs are employed for front frequency band limiting processes and back frequency band limiting processes, the memory capacity necessary for storing filter coefficients can be reduced when same filter coefficients are used. Additionally, the processes of the front speed conversion section 351 and the back speed conversion section 352 can be executed by means of a DSP that realizes the functions of the first through N-th BPFs 311 through 31n so that it is not necessary to increase the number of parts to realize them.

### (Third Embodiment)

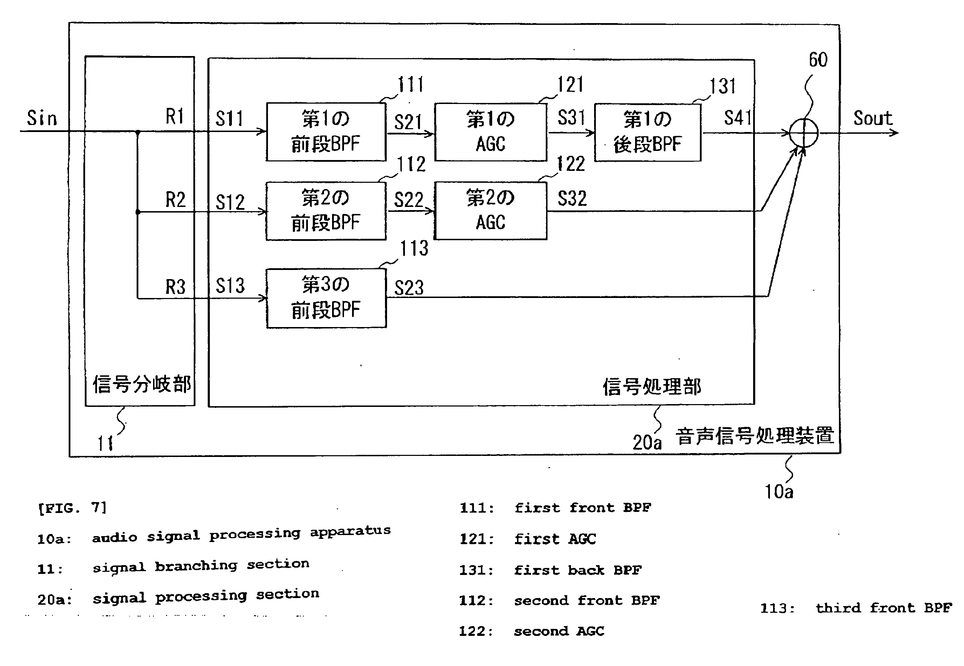

This embodiment is an example of modification made to the first embodiment. FIG. 7 is a functional block diagram of an arrangement of an audio signal processing apparatus 10a of the third embodiment of the present invention. Referring to FIG. 7, in the audio signal processing apparatus 10a, signal branching section 11 branches input audio signal Sin to produce signals **S11** through S13 for first through third routes R1 through R3. Note, however, that the number of signals produced as a result of branching is not limited to three. The signal processing section 20a executes a predetermined signal process on the divided signals S11 through S13. The adder 60 synthetically combines signals S41, S32 and S23 produced as a result of the processes executed on the routes by the signal processing section 20.

In this embodiment, the first route R1 is a route of the first category, the second route R2 is a route of the second category and the third route R3 is a route of the third category. More specifically, the first route R1 has a first front BPF 111, a first AGC 121 and a first back BPF 131 arranged in the above-mentioned order from the upstream side. The second route R2 has a second front BPF 112 and a second AGC 122. The third route R3 has only a third front BPF 113.

Note that it is so arranged that, of the first through third front BPFs 111 through 113, the first front BPF 111 selects the lowest frequency band and the third front BPF 113 selects the highest frequency band.

Thus, this embodiment is expected to provide effects similar to those of the first embodiment. Additionally, the distortions that can take place can be reduced, while preventing any fall of signal levels, by omitting only some components for AGC processes and band limiting processes, taking the distortion components that are expected to appear into consideration. Still additionally, the number of design steps of the audio signal processing apparatus 10a including those of setting parameters of BPFs can be reduced.

### (Fourth Embodiment)

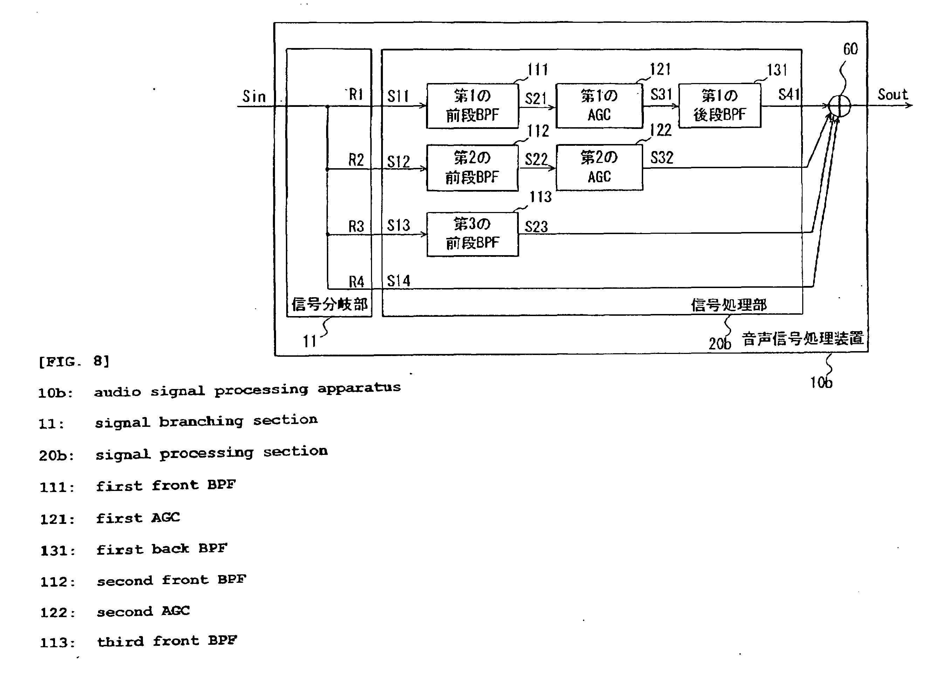

This embodiment is also an example of modification made to the first embodiment. Referring to FIG. 8, a signal processing section 20b of an audio signal processing apparatus 10b is realized by adding a fourth route R4 of the fourth category that executes neither an ACG process nor a band limiting process to the arrangement of the audio signal processing apparatus 10a of FIG. 7. Thus, an adder 60 synthetically combines four signals S41, S32 , S23 and S14 processed on the respective routes of the signal processing section 20. This embodiment is expected to provide effects similar to those of the third embodiment.

### (Fifth Embodiment)

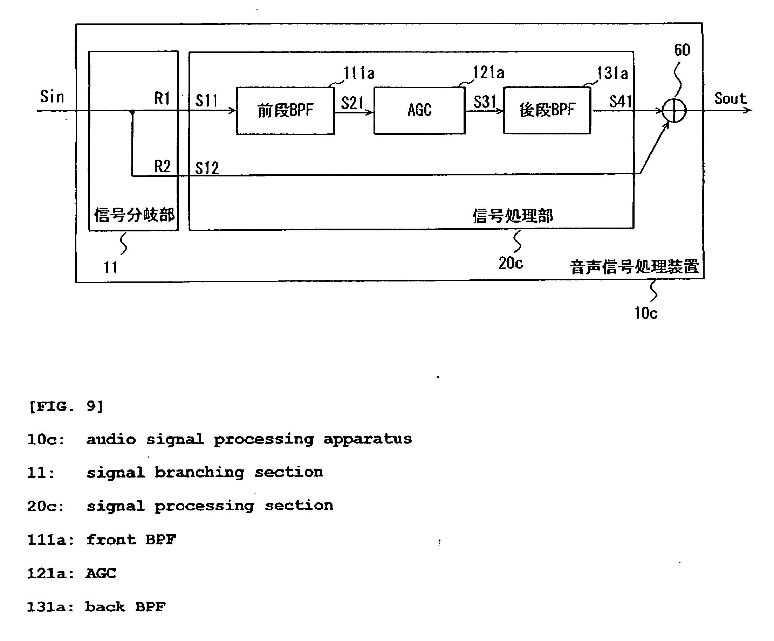

This embodiment is also an example of modification made to the first embodiment. Referring to FIG. 9, the route branching arrangement of a signal processing section 20c of an audio signal processing apparatus 10c is simplified to provide only two routes. More specifically, this embodiment is realized by omitting the second front BPF 212 from the arrangement of the experimental example shown in FIG. 3. In other words, the first route R1 is a route of the first category and the second route R2 is a route of the fourth category. To be more accurate, the first route R1 has a front BPF 111a, an AGC 121a and a back BPF 131a arranged in the above-mentioned order from the side of the signal branching section 11 and signal S41 produced as a result of the processes exerted by these components is output to adder 60. On the other hand, signal S12 that is subjected neither to any AGC process nor to any band limiting process is output to adder 60 on the second route R2. This embodiment is expected to provide effects similar to those of the third embodiment and those of the fourth embodiment.

The present invention is described above by way of the embodiments. The embodiments are only exemplary and those skilled in the art will understand that various modifications can be made to them by appropriately combining any of the components thereof without departing from the spirit and scope of the present invention.

The above embodiments can be summarized as follows.
The audio signal processing apparatus includes a front band limiting means for branching an audio signal for a plurality of routes and executing frequency band limiting processes respectively on the branched audio signals for predetermined frequency bands, a gain controlling means for controlling the gains of the audio signals divided by the front band limiting means, a back band limiting means for executing frequency band limiting processes respectively on the audio signals that are controlled for the gains thereof by the gain controlling means and a synthesizing means for synthetically combing the branched audio signals after the frequency band limiting processes by the back band limiting means.
The frequency band limiting process of the front band limiting means and that of the back band limiting means of a same route may be executed by a single band limiting means on a time sharing basis.
The gain controlling means and the back band limiting means of some of the routes of the plurality of branch routes may be omitted.
The characteristics of the front band limiting means of a route from which the gain controlling means and the back band limiting means are omitted may be set in such a way that the audio signal subjected to a frequency band limiting process by the front band limiting means of the route complements the frequency band of the audio signal on the route of an adjacent frequency band from which neither the gain controlling means nor the back band limiting means is omitted.

## Claims

1. An audio signal processing apparatus comprising:
first front band limiting means for executing a frequency band limiting process on a first audio signal;
first gain controlling means for controlling the gain of the first audio signal subjected to a frequency band limiting process by the first front band limiting means; and
first back band limiting means for executing a frequency band limiting process on the first audio signal controlled for the gain by the first gain control means.

2. The audio signal processing apparatus according to claim 1, further comprising synthesizing means for synthetically combining the first audio signal subjected to a frequency band limiting process by the first front band limiting means and an audio signal from a route different from the route of the first audio signal.

3. The audio signal processing apparatus according to claim 2, wherein
the route for outputting the audio signal to be synthetically combined with the first audio signal to the synthesizing means includes:
second front band limiting means for executing a frequency band limiting process on a second audio signal;
second gain controlling means for controlling the gain of the second audio signal subjected to a frequency band limiting process by the second front band limiting means; and
second back band limiting means for executing a frequency band limiting process on the second audio signal controlled for the gain by the second gain controlling means, and
the second audio signal is output to the synthesizing means after the frequency band limiting process by the second back band limiting means.

4. The audio signal processing apparatus according to claim 2 or 3, wherein
the frequency band of the first audio signal limited for the band by the first front band limiting means and output is set to be lower than the frequency band of the second audio signal limited for the band by the second front band limiting means and output.

5. The audio signal processing apparatus according any of claims 2 through 4, wherein
the route for outputting the audio signal to be synthetically combined with the first audio signal to the synthesizing means includes:
third front band limiting means for executing a frequency band limiting process on a third audio signal; and
third gain controlling means for controlling the gain of the third audio signal subjected to a frequency band limiting process by the third front band limiting means,
no back band limiting means for executing a frequency band limiting process on the third audio signal controlled for the gain is provided between the third gain controlling means and the synthesizing means, and
the third audio signal is output to the synthesizing means after the gain control by the third gain controlling means.

6. The audio signal processing apparatus according to any of claims 2 through 5, wherein
the route for outputting the audio signal to be synthetically combined with the first audio signal to the synthesizing means includes:
fourth front band limiting means for executing a frequency band limiting process on a fourth audio signal;
neither gain controlling means for controlling the gain of the fourth audio signal subjected to a frequency band limiting process nor front band limiting means for executing a frequency band limiting process is provided between the fourth front band limiting means and the synthesizing means, and
the fourth audio signal is output to the synthesizing means after the frequency band limiting process by the fourth front band limiting means.

7. The audio signal processing apparatus according to any of claims 2 through 6, wherein
the route of the audio signal to be synthetically combined with the first audio signal is a route for outputting the audio signal before being subjected to a band limiting process to the synthesizing means.

8. The audio signal processing apparatus according to any of claims 2 through 7, wherein
the frequency band liming process of the first front band limiting means and the frequency band limiting process of the back band limiting means are executed by a single band limiting means on a time sharing basis.

9. The audio signal processing apparatus according to claim 3, wherein
the characteristics of the second front band limiting means are so set as to complement the frequency band of the first audio signal subjected to a frequency band limiting process by the first front band limiting means.

10. An audio signal processing method to be used by an audio signal processing apparatus comprising:
a route dividing step of branching an input audio signal for a plurality of routes;
a band dividing step of dividing the audio signal for predetermined frequency bands by executing a frequency band limiting process on the audio signal in each divided route;
a gain adjusting step of adjusting, if necessary, the gain of each audio signal of the divided bands;
a distortion eliminating step of eliminating the distorted signals produced in the gain adjusting step by executing a frequency band limiting process on each audio signal adjusted for the gain; and
a synthesizing step of synthetically combining the audio signals divided for frequency bands after the end of the distortion eliminating step.

11. The audio signal processing method according to claim 10, wherein
the distortion eliminating step is omitted for any of the audio signals produced as a division for predetermined frequency bands that is not subjected to a gain adjusting step.
